# EUROPÄISCHE PATENTANMELDUNG

(11) **EP 4 227 988 A1**
(43) Veröffentlichungstag der Anmeldung: **16.08.2023**
(21) Anmeldenummer: 23152843.1
(22) Anmeldetag: 23.01.2023
(51) Int. Cl.: H01L 23/40

(54) **MONTAGERAHMEN, WÄRMEVERTEILUNGSSYSTEM, VERFAHREN ZUM ANPRESSEN EINES WÄRMEVERTEILUNGSKÖRPERS AUF EINE MIKROPROZESSORVORRICHTUNG UND VERWENDUNG EINES MONTAGERAHMENS ZUM ANPRESSEN EINES WÄRMEVERTEILUNGSKÖRPERS AUF EINE MIKROPROZESSORVORRICHTUNG**

(30) Priorität: 15.02.2022 DE 102022103542
(71) Anmelder: Thermal Grizzly Holding GmbH, 13581 Berlin (DE)
(72) Erfinder: HARTUNG, Roman, 13581 Berlin (DE); VON OPPENKOWSKI, Johannes, 13581 Berlin (DE)
(74) Vertreter: Seemann & Partner Patentanwälte mbB

(57) **Zusammenfassung**

Die Erfindung betrifft einen Montagerahmen (8), ein Wärmeverteilungssystem (2), ein Verfahren zum Anpressen eines Wärmeverteilungskörpers (6) auf eine Mikroprozessorvorrichtung (4) und eine Verwendung des Montagerahmens (8) zum Anpressen des Wärmeverteilungskörpers (6) auf die Mikroprozessorvorrichtung (4). Der Montagerahmen (8) weist einen zentralen Durchbruch (14) auf, der sich durch den Montagerahmen (8) hindurch erstreckt. Von einer Unterseite (10) des Montagerahmens (8) ist eine Ausnehmung (16) in dem Montagerahmen (8) eingelassen, die einen den Durchbruch (14) vollständig umschließenden gestuften Absatz (18) ausbildet. Der Absatz (18) bildet einen Anpressabschnitt (20) mit einer Anpressfläche (22) und einem Aufnahmeabschnitt (24) mit einer Aufnahmefläche (26) aus. Die Anpressfläche (22) ist in zwei einander gegenüberliegenden Verbreiterungsabschnitten (28) in den Aufnahmeabschnitt (24) hinein verbreitert.

## Beschreibung

Die Erfindung betrifft einen Montagerahmen zum Anpressen eines Wärmeverteilungskörpers auf eine Mikroprozessorvorrichtung.

Zudem betrifft die Erfindung ein Wärmeverteilungssystem umfassend einen Montagerahmen und einen Wärmeverteilungskörper, ein Verfahren zum Anpressen eines Wärmeverteilungskörpers auf eine Mikroprozessorvorrichtung und eine Verwendung eines Montagerahmens zum Anpressen eines Wärmeverteilungskörpers auf eine Mikroprozessorvorrichtung.

Eine große Herausforderung bei der Entwicklung von leistungsstarken Prozessoren für Computer ist die Abfuhr der im Betrieb eines solchen Prozessors auftretenden Abwärme. Da eine zu starke Hitzeentwicklung den Prozessor beschädigen kann, ist es notwendig, die entstehende Wärme effektiv abzuleiten. Zu diesem Zweck gibt es verschiedene Kühlvorrichtungen, wie zum Beispiel eine Kombination aus einem Kühlkörper und einem Lüfter, die auf der Oberseite des Prozessors angeordnet werden. Hierbei ist es von großer Wichtigkeit, dass die entstehende Wärme effektiv von dem Prozessor in die Kühlvorrichtung übertragen wird.

Vielfach umfassen Prozessoren integrierte Wärmeverteilungskörper, die im englischen als Integrated Heat Spreader (IHS) bezeichnet werden. Diese Wärmeverteilungskörper schützen den Prozessor vor Beschädigungen und verteilen dessen Abwärme, die beispielsweise in bestimmten Bereichen des Prozessors entsteht, möglichst gleichmäßig auf die vergleichsweise große Oberfläche des Wärmeverteilungskörpers. Allerdings wird die Wärmeableitung durch einen Wärmeverteilungskörper nicht notwendigerweise verbessert, da der Wärmeverteilungskörper ein zusätzliches Element zwischen Prozessor und Kühlvorrichtung darstellt, wodurch die Wärmeleitfähigkeit abnehmen kann. Gerade an den Übergängen zwischen den einzelnen Elementen ist die Wärmeleitfähigkeit reduziert, weswegen vielfach Wärmeleitpasten zwischen den Elementen eingesetzt werden, die die Wärmeleitfähigkeit an diesen Übergängen erhöhen.

Zum Fixieren des Prozessors und des Wärmeverteilungskörpers sind Wärmeverteilungssysteme mit einem Rahmen und einer Bodenplatte bekannt. Die Bodenplatte wird auf einer Platine festgeschraubt, auf der auch der Prozessorsockel angeordnet ist. Der Rahmen ist um eine Achse verschwenkbar an der Bodenplatte befestigt und weist zwei Halteflächen auf, die auf speziell ausgebildete Verbreiterungen des Wärmeverteilungskörpers drücken. Durch einen Hebel wird der Rahmen festgespannt, sodass der Rahmen durch die Halteflächen mittig auf dem Wärmeleitkörper drückt und diesen gegen den darunterliegenden Prozessor presst.

Die Aufgabe der Erfindung besteht darin, eine verbesserte thermische Ankopplung zwischen einer Mikroprozessorvorrichtung und einem Kühlkörper bereitzustellen.

Diese Aufgabe wird gelöst durch einen Montagerahmen zum Anpressen eines Wärmeverteilungskörpers auf eine Mikroprozessorvorrichtung, wobei der Montagerahmen einen zentralen Durchbruch aufweist, der sich von einer Unterseite durch den Montagerahmen hindurch bis zu einer Oberseite des Montagerahmens erstreckt, wobei von der Unterseite her eine Ausnehmung in den Montagerahmen eingelassen ist, die einen den Durchbruch vollständig umschließenden gestuften Absatz ausbildet, wobei der Absatz einen Anpressabschnitt und einen Aufnahmeabschnitt ausbildet und der Anpressabschnitt eine der Unterseite zugewandte, sich direkt an den Durchbruch anschließende und diesen vollständig umgebende Anpressfläche aufweist, wobei der den Anpressabschnitt umgebende Aufnahmeabschnitt eine die Anpressfläche vollständig umgebende, der Unterseite zugewandte Aufnahmefläche aufweist, wobei eine Materialstärke des Montagerahmens im Bereich der Anpressfläche geringer als im Bereich der Aufnahmefläche ist, so dass im Querschnitt betrachtet die Anpressfläche und die Aufnahmefläche den gestuften Absatz ausbilden, und wobei die Anpressfläche in zwei einander gegenüberliegenden Verbreiterungsabschnitten in den Aufnahmeabschnitt hinein verbreitert ist.

Der erfindungsgemäße Montagerahmen stellt mit der Anpressfläche eine im Vergleich zu herkömmlichen Lösungen deutlich vergrößerte Fläche zur Verfügung, mit der der Wärmeverteilungskörper angepresst und gehalten wird. Vorteilhaft übt der Montagerahmen anders als herkömmliche Halterahmen nicht nur auf die Verbreiterungen des Wärmeverteilungskörpers einen Anpressdruck aus, sondern entlang des gesamten äußeren Rands des Wärmeverteilungskörpers. Die Anpressfläche ist insbesondere auf einen äußeren Rand des Wärmeverteilungskörpers angepasst. Beispielsweise sind die Abmessungen der Anpressfläche auf den äußeren Rand des Wärmeverteilungskörpers angepasst, wobei berücksichtigt ist, dass sich der Wärmeverteilungskörper im laufenden Betrieb der Mikroprozessorvorrichtung aufgrund seiner Erwärmung geringfügig ausdehnt. Der Absatz des Montagerahmens ist insbesondere formkomplementär zu einem Rand des Wärmeverteilungskörpers ausgebildet, so dass der Montagerahmen an dem Wärmeverteilungskörper entlang seines Umfangs möglichst passgenau anschließt.

Es wurde erkannt, dass bei dem Rahmen aus dem Stand der Technik durch die Fixierung des Wärmeverteilungskörpers lediglich im Bereich seiner Verbreiterungen, die mittig an dessen Seiten angeordnet sind, der Wärmeverteilungskörper ungleichmäßig an die Mikroprozessorvorrichtung angedrückt wird, so dass sich ein zuverlässiger Wärmekontakt nur im mittleren Bereich, in dem der Wärmeverteilungskörper an die Mikroprozessorvorrichtung angedrückt wird, vorliegt, während in den Randbereichen in Richtung der Enden des Wärmeverteilungskörpers die Qualität des Wärmekontakts abnehmen kann. Es kann vorkommen, dass sich die äußeren Enden des Wärmeverteilungskörpers nach oben biegen, wodurch die thermische Anbindung sowohl an die Mikroprozessorvorrichtung als auch an den auf der Oberseite des Wärmeverteilungskörpers angeordneten Kühlkörper verschlechtert wird. Ein solches Durchbiegen des Wärmeverteilungskörpers verhindert also, dass die Mikroprozessorvorrichtung ihre Wärme effektiv an den Wärmeverteilungskörper und von diesem weiter in den Kühlkörper abgeben kann.

Durch den erfindungsgemäßen Montagerahmen wird der Wärmeverteilungskörper entlang seines vollständigen Umfangs, also insbesondere auch in den Randbereichen wie den äußeren Enden, an die Mikroprozessorvorrichtung angepresst, wodurch eine effiziente Wärmeabfuhr sichergestellt werden kann.

Das vollumfängliche Einspannen des Wärmeverteilungskörpers wirkt sich nicht nur positiv auf den Wärmeübergang zwischen der Mikroprozessorvorrichtung und dem Wärmeverteilungskörper, sondern ebenso positiv auf den Wärmeübergang zwischen dem Wärmeverteilungskörper und dem oberhalb angeordneten Kühlkörper aus.

Unter dem Begriff Materialstärke wird in der vorliegenden Beschreibung eine Abmessung des Montagerahmens, gemessen zwischen dessen Oberseite und Unterseite verstanden. In anderen Worten ausgedrückt ist der Montagerahmen im Aufnahmeabschnitt dicker als im Anpressabschnitt. Unter dem Begriff "verbreitert" wird verstanden, dass eine Breite der Anpressfläche in den Verbreiterungsabschnitten größer als in den übrigen Abschnitten der Anpressfläche ist. Die Breite wird insbesondere gemessen in einer Richtung, orthogonal zur Dicke bzw. Materialstärke.

Der Aufnahmeabschnitt ist insbesondere dazu ausgebildet, in einem montierten Zustand des Montagerahmens die Mikroprozessorvorrichtung einschließlich ihres platinenseitig montierten Sockels aufzunehmen, ohne Druck auf die Mikroprozessorvorrichtung auszuüben. Es wird also nur im Bereich der Anpressfläche eine Anpresskraft von dem Montagerahmen auf den darunterliegenden Wärmeverteilungskörper und die unter dem Wärmeverteilungskörper angeordnete Mikroprozessorvorrichtung ausgeübt. Der montierte Zustand des Montagerahmens liegt vor, wenn der Montagerahmen auf der Platine, beispielsweise einer Hauptplatine eines Computers, fixiert ist. Die Anpressfläche übt eine Anpresskraft auf den äußeren Rand des Wärmeverteilungskörpers aus.

Im Querschnitt betrachtet ist der Montagerahmen stufenförmig ausgebildet. Insbesondere umfasst der Montagerahmen den Absatz zwischen der Anpressfläche und der Aufnahmefläche und einen zweiten Absatz zwischen der Aufnahmefläche und einem Befestigungsabschnitt.

Der genannte Querschnitt wird in einer Ebene betrachtet, die sich zumindest annähernd senkrecht zu einer Ebene erstreckt, in der sich der Durchbruch erstreckt.

Bevorzugt sind die Verbreiterungsabschnitte der Anpressfläche in Form eines, insbesondere gleichschenkligen, Trapezes ausgebildet, dessen längere Grundseite dem Durchbruch und dessen kürzere Grundseite dem Aufnahmeabschnitt zugewandt ist.

Durch diese Form wird Platz für die Verbreiterungen des Wärmeverteilungskörpers geschaffen, sodass der Montagerahmen einen gleichmäßigen Druck auf den Wärmeverteilungskörper und nicht nur auf die Verbreiterungen ausübt. Die Anpressfläche ist insbesondere formkomplementär zu einem äußeren Rand des Wärmeverteilungskörpers ausgebildet. Insbesondere sind die Verbreiterungsabschnitte formkomplementär zu den Verbreiterungen des Wärmeverteilungskörpers ausgebildet.

Vorzugsweise hat der Durchbruch eine rechteckige Form mit zwei Querseiten, zwei Längsseiten und abgerundeten Ecken, wobei insbesondere eine Länge der Querseiten kleiner als eine Länge der Längsseiten ist, wobei insbesondere die einander gegenüberliegenden Verbreiterungsabschnitte, insbesondere mittig, an den Längsseiten des Durchbruchs anliegen.

Der Durchbruch ist insbesondere dazu ausgebildet, einen erhabenen zentralen Abschnitt des Wärmeverteilungskörpers aufzunehmen. Im montierten Zustand des Montagerahmens ist der zentrale Abschnitt im Durchbruch angeordnet. Der Montagerahmen übt somit nur im Bereich des äußeren Rands einen Druck auf den Wärmeverteilungskörper aus, nicht jedoch im Bereich des erhabenen zentralen Abschnitts. Durch den Durchbruch wird erreicht, dass eine Kühlvorrichtung auf dem Montagerahmen fixierbar ist und gleichzeitig mit dem zentralen Abschnitt eine Kontaktfläche des Wärmeverteilungskörpers für die Kühlvorrichtung bereitgestellt wird. In diesem Zustand, in dem eine Kühlvorrichtung wie ein Kühlkörper oder dergleichen auf dem Wärmeverteilungskörper montiert ist, wirkt der zentrale Abschnitt des Wärmeverteilungskörpers als Wärmeabgabeabschnitt. In dem Wärmeabgabeabschnitt tritt die Abwärme vom Wärmeverteilungskörper in die Kühlvorrichtung über.

Bevorzugt weist der Montagerahmen einen den Aufnahmeabschnitt umschließenden Befestigungsabschnitt auf, wobei eine Materialstärke des Montagerahmens im Befestigungsabschnitt größer als im Aufnahmeabschnitt ist, wobei der Befestigungsabschnitt mehrere Bohrungen zur Aufnahme von Befestigungselementen umfasst, mittels denen der Montagerahmen auf einer Platine fixierbar und auf einen äußeren Rand des Wärmeverteilungskörpers anpressbar ist.

Der Befestigungsabschnitt ermöglicht eine stabile und zuverlässige Fixierung des Montagerahmens auf einer Platine, auf der die Mikroprozessorvorrichtung angeordnet ist. Im Gegensatz zu den Systemen aus dem Stand der Technik, bei dem die Bodenplatte an der Platine fixiert und der Rahmen an der Bodenplatte befestigt wird, wird der Montagerahmen direkt auf der Platine mittels der Befestigungselemente fixiert. Dadurch wird eine stabile Fixierung und eine gute Wärmeleitfähigkeit erzielt. Auf eine Bodenplatte und eine Verschwenkbarkeit des Rahmens kann verzichtet werden. Bei den Befestigungselementen handelt es sich insbesondere um Schrauben.

Vorzugsweise ist der Montagerahmen einstückig und/oder stoffeinteilig ausgebildet. Der Montagerahmen ist bevorzugt ein mit einem spanabhebenden Verfahren hergestelltes Bauteil. Insbesondere ist der Montagerahmen als Frästeil ausgebildet. Ebenso kann der Montagerahmen ein mit einem additiven Herstellungsverfahren hergestelltes Bauteil sein. Beispielsweise ist der Montagerahmen also mit einem 3D-Druckverfahren hergestellt. Die Oberseite des Montagerahmens ist ferner insbesondere mittels Glasperlstrahlen bearbeitet.

Die einstückige und/oder stoffeinteilige Ausbildung des Montagerahmens verbessert die Wärmeleitfähigkeit im Montagerahmen selbst. Auf diese Weise wird der Tatsache Rechnung getragen, dass nicht nur durch den Wärmeverteilungskörper, sondern auch durch den Montagerahmen selbst Wärme an die Kühlvorrichtung abgegeben werden kann. Auf diese Weise wird die Wärmeleitfähigkeit des Montagerahmens weiter verbessert.

Die Aufgabe wird zudem gelöst durch ein Wärmeverteilungssystem, umfassend einen Montagerahmen nach einem der zuvor beschriebenen Ausführungsformen und einen Wärmeverteilungskörper, wobei der Wärmeverteilungskörper einen erhabenen zentralen Abschnitt und einen zum zentralen Abschnitt abgesenkten, diesen umlaufenden äußeren Rand aufweist, wobei der äußere Rand an zwei einander gegenüberliegenden Seiten abstehende, insbesondere trapezförmige, Verbreiterungen umfasst, wobei die Anpressfläche des Montagerahmens formkomplementär zu dem äußeren Rand des Wärmeverteilungskörpers ausgebildet ist und die Verbreiterungsabschnitte der Anpressfläche formkomplementär zu den Verbreiterungen des äußeren Rands ausgebildet sind.

Das Wärmeverteilungssystem verkörpert die gleichen Vorteile, Merkmale und Eigenschaften wie der zuvor beschriebene Montagerahmen. Diese treffen also in gleicher oder ähnlicher Weise vorteilhaft auch auf das Wärmeverteilungssystem zu.

Im montierten Zustand des Montagerahmens liegt die Anpressfläche des Montagerahmens auf dem gesamten äußeren Rand, also entlang des vollständigen Umfangs des Montagerahmens, des Wärmeverteilungskörpers auf, nicht nur im Bereich der Verbreiterungen. Auf diese Weise wird der Wärmeverteilungskörper entlang seines gesamten Umfangs gegen die Mikroprozessorvorrichtung gepresst. Insbesondere ist eine Vorderseite des Wärmeverteilungskörpers im montierten Zustand dem Montagerahmen zugewandt, während eine Rückseite des Wärmeverteilungskörpers der Mikroprozessorvorrichtung zugewandt ist. Der Montagerahmen ist insbesondere dazu ausgebildet, auf der Platine fixiert zu werden, sodass die Anpressfläche des Montagerahmens auf den äußeren Rand des Wärmeverteilungskörpers gepresst wird. Insbesondere umfasst das Wärmeverteilungssystem die Platine.

Vorzugsweise umfasst das Wärmeverteilungssystem die Mikroprozessorvorrichtung, wobei eine Rückseite des Wärmeverteilungskörpers auf einer Oberfläche der Mikroprozessorvorrichtung aufliegt, und insbesondere fixiert ist, wobei der Aufnahmeabschnitt des Montagerahmens dazu ausgebildet ist, den Wärmeverteilungskörper und die Mikroprozessorvorrichtung aufzunehmen.

Die Mikroprozessorvorrichtung umfasst insbesondere einen Prozessor und ein Prozessorboard, auf dem der Prozessor montiert ist sowie optional auch einen platinenseitig vorhandenen Sockel. Der Prozessor ist insbesondere in oder auf dem Sockel aufgenommen oder angeordnet und wird durch diesen in Position gehalten und elektrisch kontaktiert. Der Montagerahmen liegt im befestigten Zustand vollflächig mit dem Befestigungsabschnitt seiner Unterseite auf einer Oberseite der Hauptplatine des Computers, auf welcher der Prozessorsockel montiert ist, auf. Die Ausnehmung des Montagerahmens nimmt die Mikroprozessorvorrichtung im montierten Zustand des Montagerahmens insbesondere vollständig auf. Ferner insbesondere erstreckt sich der Befestigungsabschnitt im montierten Zustand vollständig entlang des Umfangs der Mikroprozessorvorrichtung, betrachtet in Draufsicht von oben her, auf dem montierten Prozessor.

Vorzugsweise schließt in einem montierten Zustand des Montagerahmens die Oberseite des Montagerahmens plan mit einer Oberfläche des erhabenen zentralen Abschnitts des Wärmeverteilungskörpers ab.

Auf diese Weise wird eine ebene Fläche bereitgestellt, auf der die Kühlvorrichtung fixierbar ist. Diese ebene Fläche ist größer als der zentrale Abschnitt des Wärmeverteilungskörpers allein, sodass die Montage der Kühlvorrichtung erleichtert und die Übertragung der Wärme auf die Kühlvorrichtung verbessert wird, da nicht nur durch den Wärmeverteilungskörper, sondern auch durch den Montagerahmen Wärme übertragen wird. Insbesondere ist der Durchbruch formkomplementär zu dem zentralen Abschnitt ausgebildet. Dadurch wird ein Spalt zwischen der Oberseite des Montagerahmens und dem zentralen Abschnitt vermieden, zumindest aber minimiert.

Die Aufgabe wird ferner gelöst durch ein Verfahren zum Anpressen eines Wärmeverteilungskörpers auf eine Mikroprozessorvorrichtung, wobei ein Montagerahmen nach einem der zuvor genannten Ausführungsformen auf den Wärmeverteilungskörper aufgesetzt wird, sodass die Anpressfläche des Montagerahmens vollständig auf einem äußeren Rand des Wärmeverteilungskörpers aufliegt und den Wärmeverteilungskörper gleichmäßig gegen die unter dem Wärmeverteilungskörper angeordnete Mikroprozessorvorrichtung drückt, wobei der Montagerahmen mittels mehrerer Befestigungselemente, insbesondere Schrauben, auf einer Platine fixiert wird.

Das Verfahren verkörpert die gleichen Vorteile, Merkmale und Eigenschaften wie der zuvor beschriebene Montagerahmen und das zuvor beschriebene Wärmeverteilungssystem.

Zudem wird die Aufgabe gelöst durch die Verwendung eines Montagerahmens nach einem der zuvor genannten Ausführungsformen zum Anpressen eines Wärmeverteilungskörpers auf eine Mikroprozessorvorrichtung.

Auch die Verwendung des Montagerahmens verkörpert die gleichen Vorteile, Merkmale und Eigenschaften wie der zuvor beschriebene Montagerahmen, das zuvor beschriebene Wärmeverteilungssystem und das zuvor beschriebene Verfahren zum Anpressen eines Wärmeverteilungskörpers.

Weitere Merkmale der Erfindung werden aus der Beschreibung erfindungsgemäßer Ausführungsformen zusammen mit den Ansprüchen und den beigefügten Zeichnungen ersichtlich. Erfindungsgemäße Ausführungsformen können einzelne Merkmale oder eine Kombination mehrerer Merkmale erfüllen.

Im Rahmen der Erfindung sind Merkmale, die mit "insbesondere" oder "vorzugsweise" gekennzeichnet sind, als fakultative Merkmale zu verstehen.

Die Erfindung wird nachstehend ohne Beschränkung des allgemeinen Erfindungsgedankens anhand von Ausführungsbeispielen unter Bezugnahme auf die Zeichnungen beschrieben, wobei bezüglich aller im Text nicht näher erläuterten erfindungsgemäßen Einzelheiten ausdrücklich auf die Zeichnungen verwiesen wird. Es zeigen:
- Fig. 1: eine schematisch vereinfachte Draufsicht auf eine Platine mit einer Mikroprozessorvorrichtung und einen Wärmeverteilungskörper mit Verbreiterungen am äußeren Rand,
- Fig. 2: eine schematisch vereinfachte perspektivische Ansicht eines Wärmeverteilungssystems zum Anpressen eines Wärmeverteilungskörpers auf eine Mikroprozessorvorrichtung nach dem Stand der Technik,
- Fig. 3: eine schematisch vereinfachte Darstellung eines Wärmeverteilungssystems zum Anpressen eines Wärmeverteilungskörpers auf eine Mikroprozessorvorrichtung,
- Fig. 4: eine schematisch vereinfachte perspektivische Darstellung einer Unterseite eines Montagerahmens,
- Fig. 5: eine schematisch vereinfachte Querschnittsdarstellung durch den Montagerahmen entlang einer Querschnittslinie aus Fig. 4 und
- Fig. 6: eine schematisch vereinfachte Querschnittsdarstellung durch den Montagerahmen entlang einer anderen Querschnittslinie aus Fig. 4.

In den Zeichnungen sind jeweils gleiche oder gleichartige Elemente und/oder Teile mit denselben Bezugsziffern versehen, so dass von einer erneuten Vorstellung jeweils abgesehen wird.

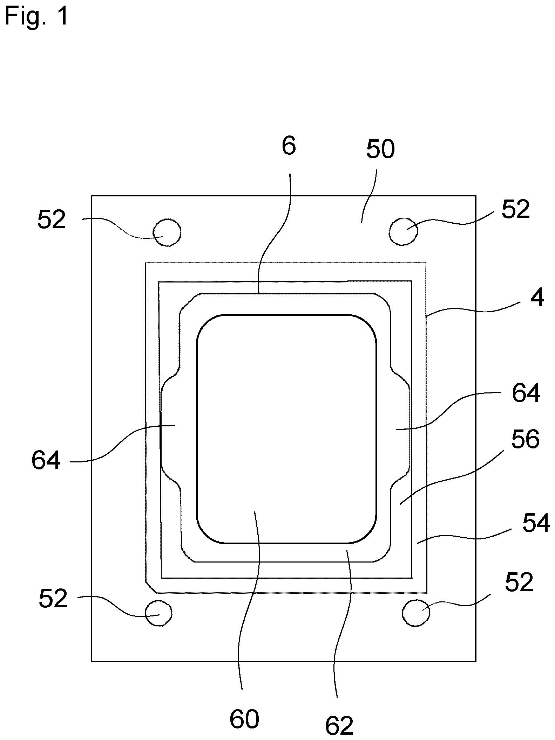

Fig. 1 zeigt schematisch vereinfacht eine Draufsicht auf eine abschnittsweise dargestellte Platine 50 eines Computers, in einem Bereich, in dem eine Mikroprozessorvorrichtung 4 mit einem Prozessor 56 auf einem Sockel 54 angeordnet ist. Die Platine 50 ist in Fig. 1 aus Gründen der Übersichtlichkeit deutlich kleiner dargestellt als dies in der Regel der Fall ist. Außerdem sind abgesehen von dem Sockel 54 weitere, typischerweise auf einer Platine 50 vorhandene, Bauteile weggelassen. Prozessoren 56 produzieren im Betrieb ein großes Maß an Abwärme. Gerade bei leistungsstarken Prozessoren 56 ist es häufig eine Herausforderung, diese Wärme effizient abzuleiten. Zum Schutz des Prozessors 56 und zur besseren Verteilung der Wärme auf eine größere Oberfläche ist auf dem Prozessor 56 ein Wärmeverteilungskörper 6 angeordnet. Der Wärmeverteilungskörper 6 umfasst einen erhabenen, nach oben abstehenden zentralen Abschnitt 60 und einen gegenüber dem zentralen Abschnitt 60 abgesenkten äußeren Rand 62. An den Längsseiten umfasst der äußere Rand 62 jeweils eine trapezförmige Verbreiterung 64, die als Halteabschnitte für einen in Fig. 1 nicht gezeigten Rahmen ausgebildet sind. Die Platine 50 umfasst mehrere Bohrungen 52, um weitere Komponenten an dieser zu fixieren. Auf den zentralen Abschnitt 60 wird eine nicht gezeigte Kühlvorrichtung aufgesetzt, die die Wärme von dem Wärmeverteilungskörper 6 aufnimmt und an die Umgebung oder ein weiteres Medium, beispielsweise eine Kühlflüssigkeit, abgibt. Beispielsweise umfasst die Kühlvorrichtung einen Kühlkörper und einen Lüfter.

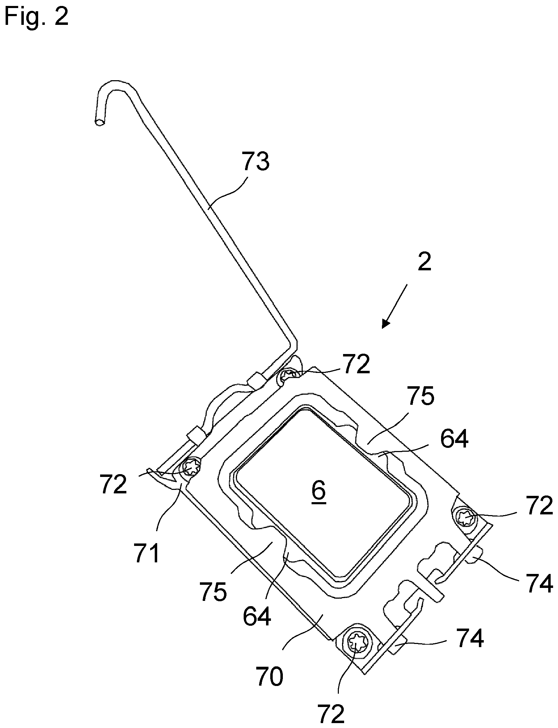

Damit eine gute Wärmeleitfähigkeit zwischen dem Prozessor 56 und dem Wärmeverteilungskörper 6 erreicht wird, ist aus dem Stand der Technik ein Wärmeverteilungssystem 2 bekannt, das in Fig. 2 schematisch vereinfacht in einer perspektivischen Darstellung gezeigt ist. Das Wärmeverteilungssystem 2 aus Fig. 2 umfasst eine Bodenplatte 71, die mittels Befestigungselementen 72 in Form von Schrauben auf der in Fig. 2 nicht dargestellten Platine 50 fixiert wird. Ein Rahmen 70 ist mittels Bügeln 74 verschwenkbar auf der Bodenplatte 71 angeordnet. Durch Betätigung eines Hebels 73 wird der Rahmen 70 nach unten gepresst, sodass vom Rahmen 70 nach innen vorstehende Halteflächen 75 auf die darunterliegenden Verbreiterungen 64 des Wärmeverteilungskörpers pressen. Anschließend wird die nicht dargestellte Kühlvorrichtung auf den Wärmeverteilungskörper 6 und den Rahmen 70 aufgesetzt.

Das in Fig. 2 dargestellte Wärmeverteilungssystem 2 erlaubt zwar eine schnelle Montage, jedoch ist die Wärmeleitfähigkeit nicht optimal. So hat sich herausgestellt, dass durch das Anpressen der Halteflächen 75 auf die Verbreiterungen 64 im mittleren Bereich des Wärmeverteilungskörpers 6 lediglich in einem zentralen Bereich des Wärmeverteilungskörpers 6 ein guter thermischer Kontakt zwischen diesem und dem darunterliegenden Prozessor 56 sichergestellt ist. Es ist möglich, dass sich beispielsweise aufgrund thermischer Einflüsse die äußeren Enden des Wärmeverteilungskörpers 6 etwas nach oben biegen, sodass an diesen Stellen kein guter Kontakt zu dem darunterliegenden Prozessor 56 erreicht wird. Die erwähnte Verbiegung des Wärmeverteilungskörpers 6 kann außerdem dazu führen, dass der oberhalb angeordnete und nicht dargestellte Kühlkörper nicht mehr vollflächig an dem zentralen Abschnitt des Wärmeverteilungskörpers 6 anliegt, und sich hierdurch die thermische Anbindung an den Kühlkörper verschlechtert.

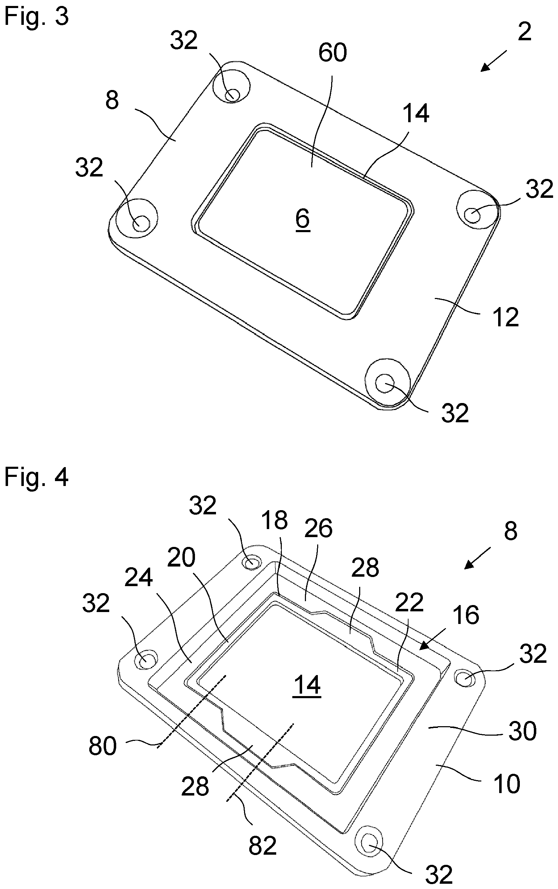

Fig. 3 zeigt schematisch vereinfacht eine perspektivische Darstellung eines Wärmeverteilungssystems 2, mit dem die Wärmeleitfähigkeit deutlich verbessert wird. Das Wärmeverteilungssystem 2 umfasst neben dem Wärmeverteilungskörper 6 einen Montagerahmen 8, der bevorzugt einstückig ausgebildet ist. Der Montagerahmen 8 hat im Wesentlichen die Form eines Quaders mit abgerundeten Ecken, der in seiner Mitte einen Durchbruch 14 aufweist, der die Form eines Rechtecks mit abgerundeten Ecken hat. Dieser Durchbruch 14 ist formkomplementär mit dem erhabenen zentralen Abschnitt 60 des Wärmeverteilungskörpers 6 ausgebildet. In einem montierten Zustand des Montagerahmens 8 schließt eine Oberseite 12 des Montagerahmens 8 plan oder zumindest näherungsweise plan bzw. eben mit einer Oberseite des zentralen Abschnitts 60 ab. Auf diese Weise wird eine große ebene Fläche bereitgestellt, auf die die Kühlvorrichtung montiert werden kann und durch die die Abwärme des Prozessors 56 effektiv an die Kühlvorrichtung abgegeben werden kann bzw. wird. Der Montagerahmen 8 umfasst zudem an seinen Ecken jeweils eine Bohrung 32, mit der der Montagerahmen 8 direkt an der Platine 50 (vgl. Fig. 1) verschraubt werden kann. Diese Art der Montage hat außerdem den Vorteil, dass im Vergleich zu der beispielsweise in Fig. 2 gezeigten herkömmlichen Lösung auf eine Bodenplatte 71 verzichtet werden kann. Der Montagerahmen 8 stellt somit im Vergleich zu dieser herkömmlichen Lösung auch eine konstruktive Vereinfachung dar.

Fig. 4 zeigt schematisch vereinfacht eine perspektivische Darstellung des Montagerahmens 8, mit Blick auf dessen Unterseite 10. Von der Unterseite 10 her ist eine Ausnehmung 16 in den Montagerahmen 8 eingelassen, die einen Absatz 18 umfasst. Mit anderen Worten ist die Unterseite 10 des Montagerahmens 8, betrachtet von außen in Richtung des zentralen Durchbruchs 14, stufenförmig ausgebildet. Eine erste Stufe bildet ein entlang eines äußeren Rands des Montagerahmens 8 verlaufender Befestigungsabschnitt 30, in dem Bohrungen 32 vorgesehen sind. Dieser Abschnitt hat die größte Materialstärke. Im montierten Zustand des Montagerahmens 8 liegt dieser Befestigungsabschnitt 30 vollflächig auf einer Oberseite der Platine 50, beispielsweise einer Hauptplatine eines Computers, auf, auf welcher der Prozessorsockel befestigt ist. Der Befestigungsabschnitt 30 umschließt einen Aufnahmeabschnitt 24, in dem der Befestigungsrahmen 8 eine kleinere Materialstärke aufweist als im Befestigungsabschnitt 30. Der Aufnahmeabschnitt 24 ist dafür vorgesehen, den Sockel 54 und den Prozessor 56 der Mikroprozessorvorrichtung 4 aufzunehmen, und zwar in dem Sinne, dass der Aufnahmeabschnitt 24 sich im montierten Zustand oberhalb eines Sockels 54 befindet, ohne jedoch auf diesen eine Kraft auszuüben. Im montierten Zustand bleibt eine nach unten gewandte Aufnahmefläche 26 des Aufnahmeabschnitts 24 also beabstandet von der Mikroprozessorvorrichtung 4, sodass von der Aufnahmefläche 26 kein Druck ausgeübt wird.

Der Aufnahmeabschnitt 24 umschließt einen Anpressabschnitt 20, der wiederum direkt an den innenliegenden Durchbruch 14 angrenzt. Im Anpressabschnitt 20 weist der Halterahmen 8 eine noch geringere Materialstärke als im Aufnahmeabschnitt 24 auf und umfasst eine nach unten gerichtete Anpressfläche 22, die formkomplementär zu dem äußeren Rand 62 des Wärmeverteilungskörpers 6 ausgebildet ist. Dementsprechend weist die Anpressfläche 22 an ihren Längsseiten zwei trapezförmige Verbreiterungsabschnitte 28 auf, die den Verbreiterungen 64 nachgebildet sind. Im montierten Zustand des Montagerahmens 8 liegt die Anpressfläche vollständig bzw. vollflächig auf dem äußeren Rand 62 des Wärmeverteilungskörpers 6 auf und drückt diesen in Richtung des darunterliegenden Prozessors. Der Halterahmen 8 liegt sowohl auf dem äußeren Rand 62 als auch auf den Verbreiterungen 64 des Wärmeverteilungskörpers 6 auf. Anders als bei herkömmlichen Lösungen wird durch den Montagerahmen 8 entlang des vollständigen Umfangs des Wärmeverteilungskörpers 6 auf diesen eine Haltekraft ausgeübt, nicht nur auf die Verbreiterung 64. Die ausgeübte Haltekraft wird durch Fixieren des Montagerahmens 8 auf der Platine 50 erzeugt. Zu diesem Zweck werden beispielsweise Schrauben durch die Bohrungen 32 des Montagerahmens 8 bis in darunterliegende fluchtend angeordnete Bohrungen 52 der Platine 50 geführt und angezogen. Wenn der Befestigungsabschnitt 30 der Unterseite 10 des Montagerahmens 8 auf einer Oberseite der Platine 50 anliegt, wird die Anpressfläche 22 auf den äußeren Rand 62 gepresst, so dass der Wärmeverteilungskörper 6 entlang seines gesamten Umfangs auf der Mikroprozessorvorrichtung 4 aufliegt, eine mechanische mit der Platine 50 fest verbundene Einheit bildet und so für eine verbesserte Wärmeleitung sorgt.

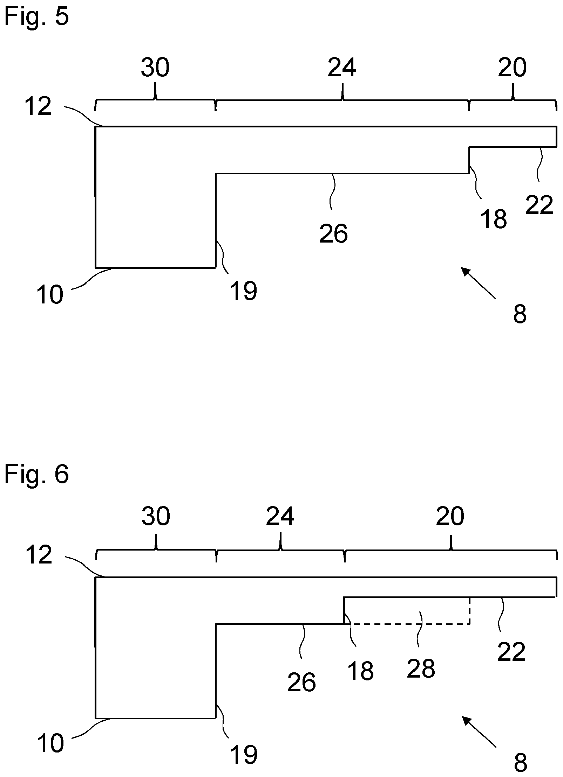

Zum besseren Verständnis des Aufbaus der Unterseite 10 des Montagerahmens 8 ist in Fig. 5 schematisch vereinfacht eine Querschnittsansicht entlang der Querschnittslinie 80 in Fig. 4 gezeigt. Fig. 6 zeigt eine Querschnittsansicht entlang der Querschnittslinie 82 aus Fig. 4. In Fig. 5 und 6 ist gut der stufenförmige Aufbau der Unterseite 10 des Montagerahmens 8 sichtbar. Der in den Fig. 5 und 6 nicht dargestellte Durchbruch 14 befindet sich in der Darstellung rechts von dem gezeigten Querschnitt. Durch den Absatz 18 wird die Anpressfläche 22 von der Aufnahmefläche 26 getrennt. Ein zweiter Absatz 19 ist zwischen dem Befestigungsabschnitt und dem Aufnahmeabschnitt 24 angeordnet. Aufgrund des Verbreiterungsabschnitts 28 ist der Anpressabschnitt 20 in dem in Fig. 6 gezeigten Querschnitt deutlich gegenüber dem Anpressabschnitt 20 in dem in Fig. 5 gezeigten Querschnitt vergrößert. Auf diese Weise wird erreicht, dass die Anpressfläche 22 gleichmäßig an dem äußeren Rand 62 anliegt und auf diese Weise der Wärmeverteilungskörper 6 effektiv auf die Mikroprozessorvorrichtung 4 gepresst wird.

Alle genannten Merkmale, auch die den Zeichnungen allein zu entnehmenden sowie auch einzelne Merkmale, die in Kombination mit anderen Merkmalen offenbart sind, werden allein und in Kombination als erfindungswesentlich angesehen. Erfindungsgemäße Ausführungsformen können durch einzelne Merkmale oder eine Kombination mehrerer Merkmale erfüllt sein.

### Bezugszeichenliste

- 2: Wärmeverteilungssystem
- 4: Mikroprozessorvorrichtung
- 6: Wärmeverteilungskörper
- 8: Montagerahmen
- 10: Unterseite
- 12: Oberseite
- 14: Durchbruch
- 16: Ausnehmung
- 18, 19: Absatz
- 20: Anpressabschnitt
- 22: Anpressfläche
- 24: Aufnahmeabschnitt
- 26: Aufnahmefläche
- 28: Verbreiterungsabschnitt
- 30: Befestigungsabschnitt
- 32: Bohrung
- 50: Platine
- 52: Bohrungen
- 54: Sockel
- 56: Prozessor
- 60: zentraler Abschnitt
- 62: äußerer Rand
- 64: Verbreiterung
- 70: Rahmen
- 71: Bodenplatte
- 72: Befestigungselement
- 73: Hebel
- 74: Bügel
- 75: Haltefläche
- 80, 82: Querschnittslinie

## Patentansprüche

1. Montagerahmen (8) zum Anpressen eines Wärmeverteilungskörpers (6) auf eine Mikroprozessorvorrichtung (4), wobei der Montagerahmen (8) einen zentralen Durchbruch (14) aufweist, der sich von einer Unterseite (10) durch den Montagerahmen (8) hindurch bis zu einer Oberseite (12) des Montagerahmens (8) erstreckt, wobei von der Unterseite (10) her eine Ausnehmung (16) in den Montagerahmen (8) eingelassen ist, die einen den Durchbruch (14) vollständig umschließenden gestuften Absatz (18) ausbildet, wobei der Absatz (18) einen Anpressabschnitt (20) und einen Aufnahmeabschnitt (24) ausbildet und der Anpressabschnitt (20) eine der Unterseite (10) zugewandte, sich direkt an den Durchbruch (14) anschließende und diesen vollständig umgebende Anpressfläche (22) aufweist, wobei der den Anpressabschnitt (20) umgebende Aufnahmeabschnitt (24) eine die Anpressfläche (22) vollständig umgebende, der Unterseite (10) zugewandte Aufnahmefläche (26) aufweist, wobei eine Materialstärke des Montagerahmens (8) im Bereich der Anpressfläche (22) geringer als im Bereich der Aufnahmefläche (26) ist, so dass im Querschnitt betrachtet die Anpressfläche (22) und die Aufnahmefläche (26) den gestuften Absatz (18) ausbilden, und wobei die Anpressfläche (22) in zwei einander gegenüberliegenden Verbreiterungsabschnitten (28) in den Aufnahmeabschnitt (24) hinein verbreitert ist.

2. Montagerahmen (8) nach Anspruch 1, **dadurch gekennzeichnet, dass** die Verbreiterungsabschnitte (28) der Anpressfläche (22) in Form eines, insbesondere gleichschenkeligen, Trapezes ausgebildet sind, dessen längere Grundseite dem Durchbruch (14) und dessen kürzere Grundseite dem Aufnahmeabschnitt (24) zugewandt ist.

3. Montagerahmen (8) nach Anspruch 1 oder 2, **dadurch gekennzeichnet, dass** der Durchbruch (14) eine rechteckige Form mit zwei Querseiten, zwei Längsseiten und abgerundeten Ecken hat, wobei insbesondere eine Länge der Querseiten kleiner als eine Länge der Längsseiten ist, wobei insbesondere die einander gegenüberliegenden Verbreiterungsabschnitte (28), insbesondere mittig, an den Längsseiten des Durchbruchs (14) anliegen.

4. Montagerahmen (8) nach einem der Ansprüche 1 bis 3, **dadurch gekennzeichnet, dass** der Montagerahmen (8) einen den Aufnahmeabschnitt (24) umschließenden Befestigungsabschnitt (30) aufweist, wobei eine Materialstärke des Montagerahmens (8) im Befestigungsabschnitt (30) größer als im Aufnahmeabschnitt (24) ist, wobei der Befestigungsabschnitt (30) mehrere Bohrungen (32) zur Aufnahme von Befestigungselementen (72) umfasst, mittels denen der Montagerahmen (8) auf einer Platine (50) fixierbar und auf einen äußeren Rand (62) des Wärmeverteilungskörpers (6) anpressbar ist.

5. Montagerahmen (8) nach einem der Ansprüche 1 bis 4, **dadurch gekennzeichnet, dass** der Montagerahmen (8) einstückig und/oder stoffeinteilig ausgebildet ist.

6. Wärmeverteilungssystem (2), umfassend einen Montagerahmen (8) nach einem der Ansprüche 1 bis 5 und einen Wärmeverteilungskörper (6), wobei der Wärmeverteilungskörper (6) einen erhabenen zentralen Abschnitt (60) und eine zum zentralen Abschnitt (60) abgesenkte, diesen umlaufenden äußeren Rand (62) aufweist, wobei der äußere Rand (62) an zwei einander gegenüberliegenden Seiten abstehende, insbesondere trapezförmige, Verbreiterungen (64) umfasst, wobei die Anpressfläche (22) des Montagerahmens (8) formkomplementär zu dem äußeren Rand (62) des Wärmeverteilungskörpers (6) ausgebildet ist und die Verbreiterungsabschnitte (28) der Anpressfläche (22) formkomplementär zu den Verbreiterungen (64) des äußeren Rands (62) ausgebildet sind.

7. Wärmeverteilungssystem (2) nach Anspruch 6 umfassend eine Mikroprozessorvorrichtung (4), wobei eine Rückseite des Wärmeverteilungskörpers (6) auf einer Oberfläche der Mikroprozessorvorrichtung (4) aufliegt, und insbesondere fixiert ist, wobei der Aufnahmeabschnitt (24) des Montagerahmens (8) dazu ausgebildet ist, den Wärmeverteilungskörper (6) und die Mikroprozessorvorrichtung (4) aufzunehmen.

8. Wärmeverteilungssystem (2) nach Anspruch 6 oder 7, **dadurch gekennzeichnet, dass** in einem montierten Zustand des Montagerahmens (8) die Oberseite (12) des Montagerahmens (8) plan mit einer Oberfläche des erhabenen zentralen Abschnitts (60) des Wärmeverteilungskörpers (6) abschließt.

9. Verfahren zum Anpressen eines Wärmeverteilungskörpers (6) auf eine Mikroprozessorvorrichtung (4), wobei ein Montagerahmen (8) nach einem der Ansprüche 1 bis 5 auf den Wärmeverteilungskörper (6) aufgesetzt wird, so dass die Anpressfläche (22) des Montagerahmens (8) vollständig auf einem äußeren Rand (62) des Wärmeverteilungskörpers (6) aufliegt und den Wärmeverteilungskörper (6) gleichmäßig gegen die unter dem Wärmeverteilungskörper (6) angeordnete Mikroprozessorvorrichtung (4) drückt, wobei der Montagerahmen (8) mittels mehrerer Befestigungselemente (72), insbesondere Schrauben, auf einer Platine (50) fixiert wird.

10. Verwendung eines Montagerahmens (8) nach einem der Ansprüche 1 bis 5 zum Anpressen eines Wärmeverteilungskörpers (6) auf eine Mikroprozessorvorrichtung (4).
